# EUROPEAN PATENT SPECIFICATION

(11) **EP 0 651 069 B1**
(45) Date of publication and mention of the grant of the patent: **31.03.1999**
(21) Application number: 94203049.5
(22) Date of filing: 20.10.1994
(51) Int. Cl.: C23C 16/26, C23C 28/04

(54) **Method for applying a friction-reducing coating**
Verfahren zum Aufbringen einer reibungsreduzierenden Schicht
Procédé d'application d'un revêtement réduisant le frottement

(30) Priority: 29.10.1993 BE 9301198
(43) Date of publication of application: 03.05.1995
(73) Proprietor: VLAAMSE INSTELLING VOOR TECHNOLOGISCH ONDERZOEK, afgekort V.I.T.O., onderneming van openbaar nut onder de vorm van een n.v., 2400 Mol (BE)
(72) Inventor: Dekempeneer, Erik, B-2390 Oostmalle (BE); Smeets, Jozef, B-2140 Borgerhout (BE); Meneve, Jan, B-9070 Wachtebeke (BE)
(74) Representative: Debrabandere, René

(56) References cited:
- EP-A- 0 474 369
- DE-A- 3 702 242
- PROCEEDINGS OT THE SPIE - THE INTERNATIONAL SOCIETY FOR OPTICAL ENGINEERING., vol.428, 1983, US pages 166 - 174 MCKENZIE D R ET AL. 'LOW EMITTANCE COATINGS FOR HIGH TEMPERATURE SOLAR COLLECTORS'
- PATENT ABSTRACTS OF JAPAN vol. 009, no. 021 (C-263) 29 January 1985 & JP-A-59 170 262 (MITSUBISHI KINZOKU KK) 26 September 1984
- PATENT ABSTRACTS OF JAPAN vol. 013, no. 111 (C-577) 16 March 1989 & JP-A-63 286 576 (IDEMITSU PETROCHEM CO LTD) 24 November 1988
- PATENT ABSTRACTS OF JAPAN vol. 016, no. 126 (C-0923) 31 March 1992 & JP-A-03 291 379 (CITIZEN WATCH CO LTD) 20 December 1991
- DATABASE WPI Section Ch, Week 8729, Derwent Publications Ltd., London, GB; Class L02, AN 87-203726 & JP-A-62 133 068 (TOSHIBA TUNGALLOY KK) 16 June 1987

## Description

The invention concerns a method for applying a friction-reducing coating providing protection against wear on a substrate, according to which method at least one intrinsic diamond-like carbon coating is deposited directly or by means of an intermediate layer on the substrate by means of a thin-film technique.

Methods whereby an intrinsic, amorphous, diamond-like carbon coating (i-C or a-C) or amorphous hydrogenated diamond-like carbon coating (a-C:H) is applied on a substrate of for example steel, offer interesting advantages since such coatings have a high hardness, a relatively low coefficient of friction and a chemical inertness, which results in a good resistance against wear and corrosion.

Such methods are described among others in "Thin Solid Films" 217 (1992) 56 and "Diamond and Related Materials" 2 (1993) 272.

However, the coefficient of friction of such coatings depends on the surrounding air humidity. Thus, it is known that the coefficient of friction increases from for example 0.05 in a dry nitrogen atmosphere or in a very high vacuum up to a value between 0.15 and 0.4 at a relative humidity of 50%. The high internal compressive stress in these diamond-like carbon coatings may also cause adherence problems, as a result of which the thickness remains restricted to for example 2000 nm.

The invention aims to remedy said disadvantages and to provide a method for applying a coating on a substrate providing protection against wear with which a coating with still better qualities can be obtained and among others a lower coefficient of friction, independent of the air humidity.

This aim is reached according to the invention as at least one time successively an intrinsic diamond-like carbon coating and on top thereof and in immediate contact of it a silicon alloyed diamond-like carbon coating (a-Si₁₋ₓCₓ:H) are deposited by means of a thin-film technique on the substrate or on an intermediate layer of silicon deposited on the substrate.

Surprisingly, it appeared that in this manner the excellent tribological qualities of both coatings are combined. The thus obtained multi-layer has, apart from an exceptionally high resistance against wear which is typical of the intrinsic diamond-like carbon coating, also a very low coefficient of friction which is independent of the prevailing air humidity, such as with a single silicon alloyed diamond-like carbon coating. Moreover, the internal stresses of this multi-layer are lower compared to those of intrinsic diamond-like carbon coatings.

The use of silicon alloyed diamond-like carbon coatings, also called amorphous hydrogenated silicon/carbon alloys (a-Si₁₋ₓCₓ:H) is known as such. Such layers are used because of the low coefficient of friction which is obtained for a silicon atom content between 10 and 40% and which is independent of the prevailing air humidity. Also the internal stresses in the layer are relatively small, such that this layer can be made relatively thick. However, this silicon alloyed diamond-like coating, which is used alone as such, has a lower resistance against wear than the intrinsic diamond-like carbon coatings as a result of structural changes in the material due to the silicon. The latter is described among others in "Diamond and Related Materials" 1 (1992) 553, "Surface and Coatings Technology", 62 (1993) 577 and "Journal de Physique II" 3 (1993) 503. However, nothing seemed to indicate that by using such an alloyed diamond-like coating together with an intrinsic diamond-like carbon coating the advantages of both layers together could be obtained.

DE-A-3.702.242 discloses the use of a 50 to 100 nm thick a-Siₓ-N_{y}-C_{z}:H interlayer on a non-defined substrate in order to improve the adherence of an intrinsic diamond-like carbon coating (i-C), through the formation of Si-C and Si-N bonds. a-Siₓ-N_{y}-C_{z}:H layers with a thickness of 20 to 50 nm can also be combined with i-C into a multilayer structure to reduce the internal stresses of the coating.

"Proceedings of the SPIE - The International Society for Optical Engineering", vol. 428,1983, US, pages 166-174, MCKENZIE D.R. et al., "Low emittance coatings for high temperature solar collectors", describes different material combinations for low emission coatings in solar collectors. Such combinations are: pure a-C:H, pure a-Si:H, pure a-SiC:H, a three layer system a-C:H/a-Si:H/a-C:H, and a three layer system comprising an intermediate amorphous silicon layer and thereon a gradient a-SiₓC₁₋ₓ:H layer where x varies from 0,5 to 0 from the bottom to the top and on top an a-C:H layer. Moreover all layers are annealed what means that none of them is diamond-like.

JP-A-59.170.262 discloses the application of a multi-layer coating consisting of diamond (not diamond-like (a-C:H)), carbides, nitrides. carbonitrides or oxycarbonitrides of the IVa, Va and VIa group metals Si of B in order to improve the wear resistance and cutting performance of an iron alloy tool member. Diamond (crystalline Sp³C) is however a completely different material from a-C:H, which is called "diamond-like" only because of its high hardness and chemical inertness. a-C:H has an amorphous micro-structure which results in a smooth surface.

JP-A-63.286.576 describes a method to improve the adhesion of an a-C:H coating on an undefined substrate through the application of an a-Si₁₋ₓCₓ:H interlayer, but does not refer to a multilayer coating.

In EP-A-0.474.369 is explained that an ion-assisted process produces diamond-like carbon coatings only on a limited number of substrates such as silicon, alumina, silicon nitride, and other ceramics. In the case of steel, nickel, germanium and other similar materials a soft graphitic carbon layer is obtained rather than a diamond-like carbon layer. This can be overcome by using an interlayer, a so-called foundation layer, consisting of silicon nitride, silicon, alumina and boron nitride.

JP-A-03.291.379 discloses the use of a multi-layer coating consisting of alternating layers of a-C:H and Si, Ge, Ti, TiN, Zr or ZrN in order to reduce the internal stresses inherently present in the hard a-C:H layers. This prevents the spontaneous peeling-off of the coating. In this way, the resistance against wear, impact and corrosion of the coating would be enhanced. a-Si₁₋ₓCₓ:H is however not explicitly named as possible layer material.

JP-A-62.133,068 refers to an interlayer structure for depositing a diamond and/or diamond-like coating on an undefined substrate. The interlayer consists of a stack of VIa,Va and VIa metals or Si and their carbides, nitrides or mutual solid solutions and diamond and/or diamond-like carbon layers. The resulting coating is used for grinding tools, heat sinks and loudspeakers. The document does refer to an interlayer for improved adhesion of the outer diamond and/or diamond-like carbon coating.

In a peculiar embodiment of the invention combinations consisting of an intrinsic diamond-like carbon coating and on top thereof a silicon alloyed diamond-like carbon coating (a-Si₁₋ₓCₓ:H) are successively deposited several times up to a total number of layers between 2 and 5,000, and for example between 4 and 50.

According to a practical embodiment of the invention, layers are applied with a thickness between 2 and 5,000 nm, and for example with a thickness of about 200 nm.

In a special embodiment of the invention the intrinsic and the silicon alloyed diamond-like carbon coatings are applied on the substrate by means of plasma-assisted chemical vapour deposition or PACVD at a temperature below 350°C.

Other particularities and advantages of the invention will become clear from the following description of a method for applying a friction-reducing coating providing protection against wear on a substrate, according to the invention. This description is given as an example only and does not limit the invention in any way. The figures refer to the accompanying drawings, where:
figure 1 shows a diagram of the coefficient of friction as a function of time during a ball-on-disk test for an intrinsic diamond-like carbon coating;
figure 2 shows a diagram analogous to that in figure 1, but for a silicon alloyed diamond-like carbon coating;
figure 3 shows a diagram analogous to that in figure 2, but now for a lower normal force, which illustrates the intrinsic low coefficient of friction of this type of coating;
figure 4 shows a diagram analogous to those in the previous figures, but for a multi-layer applied according to the invention.

To apply a coating with an exceptionally high resistance against wear and moreover a very low coefficient of friction which is independent of the prevailing air humidity, a multi-layer consisting of subsequent layers of intrinsic diamond-like carbon (a-C:H) and silicon alloyed diamond-like carbon (a-Si₁₋ₓCₓ:H) is applied on the substrate according to a thin-film technique known as such. These layers can be applied one or several times, whereby an intrinsic diamond-like carbon coating is alternated with a silicon alloyed diamond-like carbon coating.

The total number of layers can be situated between 2 and 5,000 and is for example situated between 4 and 50. Practically, the thickness of these layers is situated between 2 and 5,000 nm and amounts for example to 200 nm.

An appropriate thin-film technique to apply these subsequent layers is the PACVD technique (plasma-assisted chemical vapour deposition), whereby the intrinsic diamond-like carbon layers are made on the basis of a plasma of methane and the silicon alloyed diamond-like carbon layers are made on the basis of a plasma of a mixture of methane and silane. This can be obtained in a very simple manner by keeping the methane supply constant during the plasma deposition process and by starting and stopping the silane supply according to a selected time schedule. The other process parameters such as the operating pressure, radio frequency power, cathode self-bias and temperature are hereby maintained constant. The deposition temperature is hereby kept below 350°C, as a result of which the choice of substrate materials is practically limitless.

In so far as the substrate is made of steel, iron or alloys thereof, it is recommended to clean the substrate surface first by means of for example a plasma/etching process and to subsequently apply an intermediate silicon layer by means of said PACVD technique before letting the multi-layer grow. An intermediate layer of 20 nm will do.

The invention will be further illustrated by means of the following example:

### EXAMPLE.

A substrate of stainless steel UNI X5CrNi810 was put on the cathode of a PACVD reactor. In this reactor was created a vacuum with a final pressure of 10⁻³ Pa and subsequently an Ar plasma was lit during some five minutes in order to clean the substrate surface by means of a plasma/etching process.

A thin intermediate layer of silicon was allowed to grow on the cleaned substrate surface on the basis of a silane/hydrogen gas mixture. The aim of this intermediate layer with a thickness of 20 nm is to improve the adherence of the subsequent layers.

Without causing the plasma to expand the silane/hydrogen supply was gradually replaced by methane and the first a-C:H layer of the multi-layer was allowed to grow (STAGE A). Thanks to the gradual transition of silane to methane, a gradual transition of the intermediate silicon layer to the first layer of the multi-layer was obtained, which has a positive effect on the bond. During the deposition of the a-C:H layer, the parameters were as follows:
- pressure: 1.5 Pa
- flow: 0.017 Pa.m³s⁻¹ (10 sccm)
- rf power: 35 W
- cathode bias: 300 V
- deposition time: 40 min.
- thickness of layer: 200 nm

After the deposition time of 40 min. the silane supply was opened again and a second a-Si_{0.2}C_{0.8}:H layer was allowed to grow (STAGE B). The process parameters were the same as in the previous stage, except for the flow and the deposition time. The flow of methane was unaltered, but 0.0017 Pa.m³s⁻¹ (1 sccm) was added to it. The deposition time was only 35 min., but the thickness of the layer was the same, namely 200 nm.

By subsequently alternately stopping and re-opening the silane supply, the latter two stages A and B were repeated four times. In this manner was obtained a multi-layer consisting of five a-C:H layers, alternated with five a-Si₁₋ₓCₓ:H layers, whereby x = 0.8. Consequently, the total thickness of the multi-layer amounted to 2,000 nm, the intermediate silicon layer not included.

This multi-layer was tested by means of the ball-on-disk test with a normal force of 10 N. According to this wear test, a steel ball (UNI 102Cr6KU) with a diameter of 6.35 mm was pressed with said normal force against the horizontally fixed, coated substrate. The atmosphere inside the test space consisted of damp nitrogen with 50% relative humidity. No lubricants were used. The substrate was made to turn at a rotation speed of 500 r/min. The eccentricity of the ball was 6 mm. During the test, the tangential frictional force was measured. The ratio between said tangentional force and the constant normal force represents the coefficient of friction. When the coefficient of friction exceeds a value 0.5, the test is automatically brought to an end (the coefficient of friction between the ball and the non-coated substrate is normally 0.6 under the same circumstances). The time between the beginning and the automatic stopping of the test indicates the age of the studied coating and is characteristic for the wear resistance of said coating. The intrinsic coefficient of friction of the coating is the minimum steady coefficient of friction before the layer partially fails within the wear track, which results in an increase of the coefficient of friction. Also the period during which the coating had a coefficient of friction smaller than 0.1 was consistently noted.

The test results of the multi-layer obtained according to the example are represented in figure 4, in which the coefficient of friction as a function of time is represented in hours. As is shown in this figure, the coefficient of friction was 0.06 and the age 29 hours and 16 min. After 12.5 hours, the coefficient of friction exceeded 0.1.

In comparison, a substrate was coated according to two reference examples, with an intrinsic diamond-like carbon coating alone and with a silicon alloyed diamond-like carbon coating alone respectively.

### REFERENCE EXAMPLE I.

The substrate described in the above-mentioned example was cleaned by means of a plasma/etching process and provided with an intermediate silicon layer according to the method described in said example. Further, only an a-C:H layer was applied in said stage A of the example. The parameters were exactly the same, except for the deposition time and the layer thickness, which was 1,500 nm.

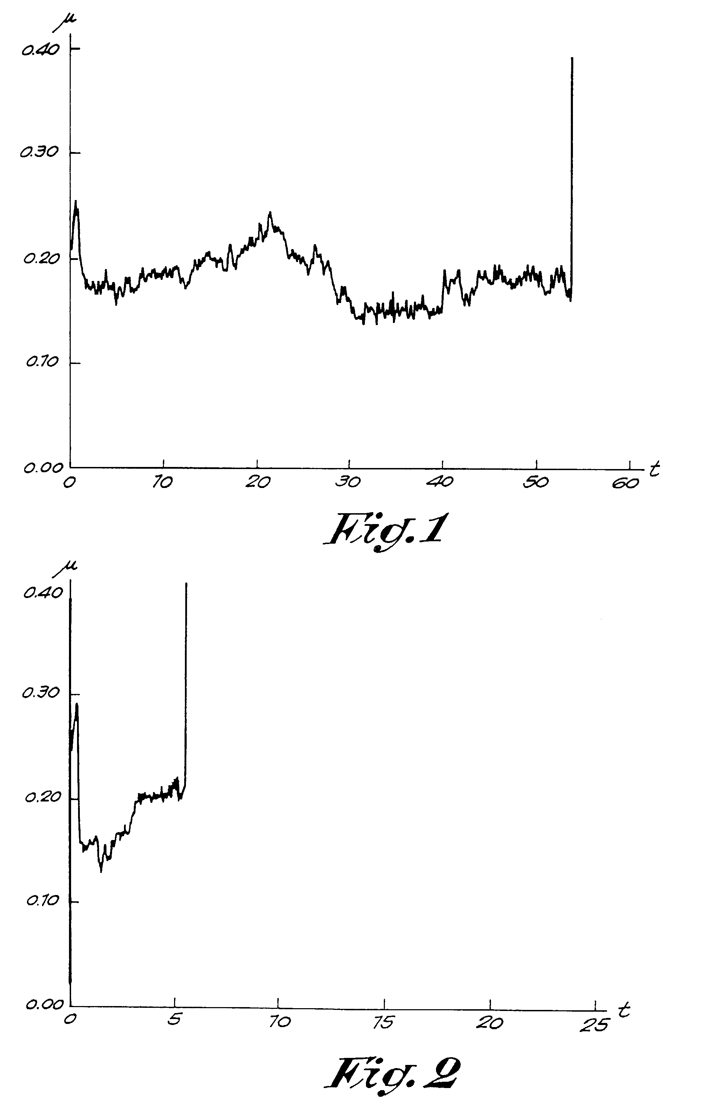

When carrying out the above-described ball-on-disk wear test, a coefficient of friction of 0.15 to 0.25 was obtained and an age of 53 hours and 15 minutes, despite the smaller layer thickness (1,500 nm instead of 2,000 nm). From the start, the coefficient of friction exceeded 0.1. The results of this test (namely the coefficient of friction as a function of time in hours) are represented in figure 1.

### REFERENCE EXAMPLE II.

The same substrate as described in the example was cleaned by means of a plasma/etching process and provided with an intermediate silicon layer according to the manner described therein.

One single silicon alloyed diamond-like carbon layer a-Si_{0.2}C_{0.8}:H was applied on this substrate in said stage B of the example. The parameters were exactly the same, except for the deposition time and the layer thickness, which was 2,000 nm.

When carrying out the above-mentioned ball-on-disk wear test, no intrinsic coefficient of friction could be determined as the wear resistance of this silicon alloyed diamond-like carbon coating was so low that it already failed partially at the beginning of the test. An age of 5 hours and 26 min. was recorded. Already from the start, the coefficient of friction was bigger than 0.1.

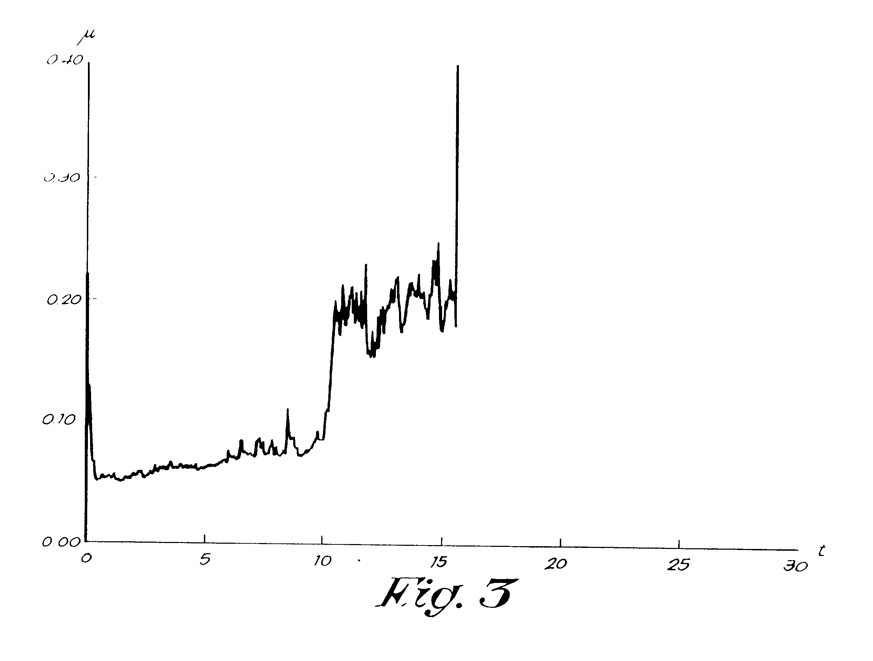

The results which represent the coefficient of friction as a function of time in hours are represented in figure 2.

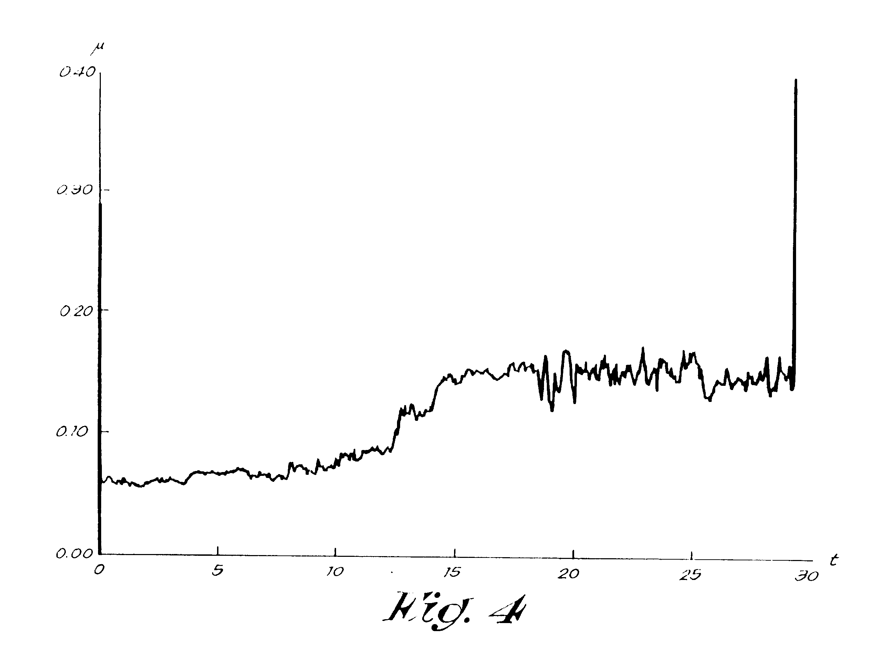

An illustration of the intrinsic coefficient of friction as a function of time in hours of this type of layer can be found in figure 3. For this ball-on-disk measurement, the normal force was reduced from 10 N to 5 N.

When comparing the results of the example with the results of the reference examples it is clear that by superposing intrinsic diamond-like carbon layers and silicon alloyed diamond-like carbon layers in one single multi-layer, both the high wear resistance of intrinsic diamond-like carbon and the low coefficient of friction, independent of the prevailing air humidity, of the silicon alloyed diamond-like carbon layer are obtained.

The invention is by no means limited to the above-described embodiments; on the contrary, within the scope of the patent application, many changes can be made to the described embodiments according to the invention.

In particular, the used parameters such as operating pressure, gas flows, rf power, cathode self-bias and temperature may largely vary. The limits depend among others on the geometry of the reactor. The parameters for STAGE A will be selected such in practice that this stage entails the growth of a highly wear-resistant diamond-like carbon coating. Such parameters can be found in related literature. The parameters for STAGE B are preferably selected such that a reasonably wear-resistant a-Si₁₋ₓCₓ:H is also made and thus preferably identical to the one with which a-C:H coatings are presently made whereby the silane/methane gas flow ratio is set such that x is situated between 0.6 and 0.9.

The number of layers in the multi-layer does not necessarily have to be 10. This number may vary, as well as the thickness of the layers.

All parameters can be optimized as a function of the required multi-layer qualities.

The methane and silane precursors may possibly be replaced by others. Alternatives for methane are for example ethane and butane, whereas the toxic silane can be replaced for example by the less dangerous tetramethylsilicon (Si(CH₃)4).

Other thin-film techniques than PACVD can be used to apply the layers. In principle, all techniques with which good intrinsic and silicon alloyed diamond-like carbon coatings can be made to grow are suitable, such as for example physical vapour deposition techniques whereby layers are made by means of the reactive atomization of a silicon object in the presence of a mixture of inert carbon-containing gases.

The substrate does not necessarily have to be stainless steel. The choice of the substrate is only restricted by the deposition temperature (for example the tempering of steel types, the weakening and/or melting of plastics, etc.) The low deposition temperature with PACVD makes the choice of substrate materials practically limitless.

## Claims

1. Method for applying a friction-reducing coating providing protection against wear on a substrate, according to which method at least one intrinsic diamond-like carbon coating is deposited directly or by means of an intermediate layer on the substrate by means of a thin-film technique, characterized in that at least one time successively an intrinsic diamond-like carbon coating and on top and in immediate contact of it a silicon alloyed diamond-like carbon coating (a-Si₁₋ₓCₓ:H) are deposited by means of a thin-film technique-on the substrate or on an intermediate layer of silicon deposited on the substrate.

2. Method according to claim 1, characterized in that combinations consisting of an intrinsic diamond-like carbon coating and on top thereof a silicon alloyed diamond-like carbon coating (a-Si₁₋ₓCₓ:H) are successively deposited several times up to a total number of layers between 2 and 5,000.

3. Method according to claim 2, characterized in that between 4 and 50 layers are applied.

4. Method according to any one of claims 1 to 3, characterized in that layers with a thickness between 2 and 5,000 nm are applied.

5. Method according to claim 4, characterized in that layers with a thickness of about 200 mm are applied.

6. Method according to any one of claims 1 to 5, characterized in that the intrinsic and the silicon alloyed diamond-like carbon coatings are applied on the substrate by means of plasma-assisted chemical vapour deposition (PACVD) at a temperature below 350°C.

7. Method according to claim 6, characterized in that the subsequent layers are applied by litting a plasma of a carbon precursor and by adding a silicon precursor to this carbon precursor each time a silicon alloyed diamond-like layer is required.

8. Method according to any one of claims 1 to 7, characterized in that a substrate of steel is used and in that an intermediate layer of silicon is applied between the substrate and the first layer after the substrate surface was cleaned by means of for example a plasma/etching process.

## Patentansprüche

1. Verfahren zum Aufbringen einer reibungsreduzierenden Schicht, die für Schutz gegen Verschleiß auf einem Substrat sorgt, gemäß welchen Verfahrens zumindest eine intrinsische diamantartige Kohlenstoffschicht mittels einer Dünnschichttechnik direkt oder mittels einer Zwischenschicht auf dem Substrat abgelagert wird, dadurch gekennzeichnet, daß zumindest einmal aufeinanderfolgend eine intrinsische diamantartige Kohlenstoffschicht und darauf und in unmittelbarem Kontakt damit eine siliziumlegierte diamantartige Kohlenstoffschicht (a-Si₁₋ₓCₓ:H) mittels einer Dünnschichttechnik auf dem Substrat oder auf einer auf dem Substrat aufgebrachten Zwischenschicht aus Silizium abgelagert werden.

2. Verfahren gemäß Anspruch 1, dadurch gekennzeichnet, daß Kombinationen, bestehend aus einer intrinsischen diamantartigen Kohlenstoffschicht und auf dieser einer siliziumlegierten diamantartigen Kohlenstoffschicht (a-Si₁₋ₓCₓ:H) aufeinanderfolgend mehrere Male bis zu einer Gesamtanzahl von Schichten zwischen 2 und 5000 abgelagert werden.

3. Verfahren gemäß Anspruch 2, dadurch gekennzeichnet, daß zwischen 4 und 50 Schichten aufgebracht werden.

4. Verfahren gemäß einem der Ansprüche 1 bis 3, dadurch gekennzeichnet, daß Schichten mit einer Dicke zwischen 2 und 5000 nm aufgebracht werden.

5. Verfahren gemäß Anspruch 4, dadurch gekennzeichnet, daß Schichten mit einer Dicke von etwa 200 nm aufgebracht werden.

6. Verfahren gemäß einem der Ansprüche 1 bis 5, dadurch gekennzeichnet, daß die intrinsischen und die siliziumlegierten diamantartigen Beschichtungen mittels plasma-unterstützten chemischen Aufdampfens (PACVD) bei einer Temperatur unter 350°C auf das Substrat aufgebracht werden.

7. Verfahren gemäß Anspruch 6, dadurch gekennzeichnet, daß die aufeinanderfolgenden Schichten aufgebracht werden, indem ein Plasma eines Kohlenstoffvorläufers entzündet wird und diesem Kohlenstoffvorläufer jedesmal, wenn eine siliziumlegierte diamantartige Schicht benötigt wird, ein Siliziumvorläufer zugesetzt wird.

8. Verfahren gemäß einem der Ansprüche 1 bis 7, dadurch gekennzeichnet, daß ein Substrat aus Stahl verwendet wird und daß eine Zwischenschicht aus Silizium zwischen dem Substrat und der ersten Schicht aufgebracht wird, nachdem die Substratoberfläche mittels beispielsweise eines Plasma-/Ätzvorgangs gereinigt wurde.

## Revendications

1. Procédé pour appliquer sur un substrat un revêtement réduisant la friction, qui procure une protection contre l'usure, procédé conformément auquel on dépose au moins un revêtement de carbone intrinsèque analogue à du diamant, directement ou à l'aide d'une couche intermédiaire, sur le substrat via une technique en film mince, caractérisé en ce qu'on dépose au moins une fois successivement un revêtement de carbone intrinsèque analogue à du diamant et, par-dessus ce dernier et en contact intime avec lui, un revêtement de carbone analogue à du diamant allié au silicium (a-Si₁₋ₓCₓ:H) à l'aide d'une technique en film mince sur le substrat ou sur une couche intermédiaire de silicium déposée sur le substrat.

2. Procédé selon la revendication 1, caractérisé en ce qu'on dépose successivement des combinaisons constituées par un revêtement de carbone intrinsèque analogue à du diamant et, par-dessus ce dernier, un revêtement de carbone analogue à du diamant allié au silicium (a-Si₁₋ₓCₓ:H), à plusieurs reprises jusqu'à ce que l'on obtienne un nombre total de couches entre 2 et 5.000.

3. Procédé selon la revendication 2, caractérisé en ce qu'on applique entre 4 et 50 couches.

4. Procédé selon l'une quelconque des revendications 1 à 3, caractérisé en ce qu'on applique des couches possédant une épaisseur entre 2 et 5.000 nm.

5. Procédé selon la revendication 4, caractérisé en ce qu'on applique des couches possédant une épaisseur d'environ 200 nm.

6. Procédé selon l'une quelconque des revendications 1 à 5, caractérisé en ce qu'on applique les revêtements de carbone intrinsèque analogue à du diamant et de carbone analogue à du diamant allié au silicium sur le substrat à l'aide d'une déposition en phase vapeur par procédé chimique assistée par plasma (PACVD) à une température inférieure à 350°C.

7. Procédé selon la revendication 6, caractérisé en ce qu'on applique les couches ultérieures en allumant un plasma d'un précurseur du carbone et en ajoutant un précurseur de silicium à ce précurseur du carbone chaque fois que l'on a besoin d'une couche analogue à du diamant allié au silicium.

8. Procédé selon l'une quelconque des revendications 1 à 7, caractérisé en ce qu'on utilise un substrat en acier et en ce qu'on applique une couche intermédiaire de silicium entre le substrat et la première couche après avoir nettoyé la surface du substrat par exemple à l'aide d'un procédé d'attaque au plasma.
